# EUROPEAN PATENT APPLICATION

(11) **EP 2 325 912 A1**
(43) Date of publication of application: **25.05.2011**
(21) Application number: 09809810.6
(22) Date of filing: 12.08.2009
(51) Int. Cl.: H01L 51/42

(54) **ORGANIC PHOTOELECTRIC CONVERSION ELEMENT AND FABRICATION METHOD THEREFOR**

(30) Priority: 29.08.2008 JP 2008221084; 19.03.2009 JP 2009067796
(71) Applicant: Sumitomo Chemical Company, Limited, Tokyo 104-8260 (JP)
(72) Inventor: UETANI, Yasunori, Tsukuba-shi Ibaraki 305-0045 (JP)
(74) Representative: Vossius & Partner
(86) International application number: PCT/JP2009/064479
(87) International publication number: WO 2010/024157

(57) **Abstract**

Disclosed is an organic photoelectric conversion element that comprises a cathode; an anode, which is formed on a substrate by an application method; and an active layer, which is disposed between the anode and the cathode; wherein the anode contains polyaniline, a polyaniline derivative or a mixture of a polyaniline and a polyaniline derivative.

## Description

### TECHNICAL FIELD

The present invention relates to an organic photoelectric conversion element and a method for fabricating the same.

### BACKGROUND ART

In recent years, organic photoelectric conversion elements (organic solar cells, optical sensors,etc.) utilizing light energy attract attention. The organic solar cells have a constitution including an anode, a cathode and an active layer, and particularly, organic solar cells of a bulk heterojunction type, which has an active layer containing an n-type semiconductor and a p-type semiconductor, attract attention. A transparent thin film usually composed of indium tin oxide (ITO) is used for the anode of the organic solar cell (refer to, for example, Applied Physics Letters vol. 58 (1991), p1062) .

The thin film composed of ITO is generally prepared on a substrate by a sputtering method, but since this method requires a vacuum apparatus, its productivity is low. Therefore, it is preferable to prepare a transparent electrode by an application method which is more convenient from the viewpoint of productivity. For example, there is known a photoelectric conversion element provided with a transparent electrode formed by an application method using highly conductive poly(3,4-ethylenedioxythiophene) (PEDOT) /poly (4-styrenesulfonic acid) (PSS) (refer to Applied Physics Letters vol. 92 (2008), p143307, Applied Physics Letters vol. 92 (2008), p233308) . Specifically, this transparent electrode is formed by an application method, using a coating solution prepared by adding dimethylsulfoxide (DMSO) to a suspension of PEDOT/PSS.

### DISCLOSURE OF THE INVENTION

However, a photoelectric conversion element provided with an anode formed by use of PEDOT/PSS is not sufficient in photoelectric conversion efficiency.

It is an object of the present invention to provide an organic photoelectric conversion element high in photoelectric conversion efficiency, using a transparent or translucent anode which can be easily formed by an application method.

The present invention relates to an organic photoelectric conversion element comprising:
a cathode;
an anode formed on a substrate by an application method; and
an active layer disposed between the anode and the cathode;
wherein the anode contains polyaniline, a polyaniline derivative or a mixture of polyaniline and a polyaniline derivative.

The present invention also relates to an organic photoelectric conversion element further comprising a functional layer which is placed between the active layer and the anode so as to be in contact with the active layer and the anode and is formed by an application method using a solution with a pH of 5 to 9.

The present invention further relates to the organic photoelectric conversion element wherein the active layer is formed by an application method.

The present invention further relates to the organic photoelectric conversion element wherein the active layer contains a conjugated polymer compound and a fullerene derivative.

The present invention further relates to a method for fabricating an organic photoelectric conversion element having an anode, a cathode and an active layer disposed between the anode and the cathode, including the steps of:
forming an anode on a substrate by an application method using a coating solution containing polyaniline, a polyaniline derivative, or a mixture of polyaniline and a polyaniline derivative;
forming an active layer by an application method; and forming a cathode.

### MODE FOR CARRYING OUT THE INVENTION

Hereinafter, the present invention will be described in detail.

### <Organic Photoelectric Conversion Element>

The organic photoelectric conversion element of the present invention comprises a cathode, an anode formed on a substrate by an application method, and an active layer disposed between the anode and the cathode, and the anode contains polyaniline, a polyaniline derivative, or a mixture of polyaniline and a polyaniline derivative. The organic photoelectric conversion element of the present embodiment is configured by stacking an anode, an active layer and a cathode in this order from a substrate side. There may be cases where a predetermined layer such as a functional layer described later is disposed between the active layer and the anode, and/or between the active layer and the cathode.

At least one of the anode and the cathode of the organic photoelectric conversion element is a transparent or translucent electrode, and light is introduced through the transparent or translucent electrode. In the organic photoelectric conversion element of the present embodiment, the anode is transparent or translucent, and when a transparent or translucent substrate is employed, light is introduced through the substrate and the anode. Light energy passing through the transparent or translucent electrode is absorbed by an electron acceptive compound and/or an electron donating compound, which constitutes the active layer, to produce an exciton in which an electron and a hole are combined into one. When the produced exciton moves and reaches a heterojunction interface where the electron acceptive compound and the electron donating compound exist next to each other, the exciton is separated into the electron and the hole due to a difference between HOMO energy and LUMO energy of the respective compounds at the interface to generate charges (electron and hole) which can independently move. The generated charges are respectively travel to electrodes, and thereby the charges can be externally drawn out as electric energy (electric current).

### (Substrate)

It is preferred that the substrate is not deformed when the organic photoelectric conversion element is formed. Examples of the materials of the substrate include glass, plastic, and silicon. When the organic photoelectric conversion element is prepared on an opaque substrate, a cathode opposite to an anode disposed on the substrate side is preferably transparent or translucent, and by employing such a transparent or translucent cathode, light can be introduced from a cathode side.

### (Anode)

The anode contains polyaniline and/or derivatives thereof, and is formed on a substrate by an application method using a coating solution containing polyaniline, a polyaniline derivative, or a mixture of polyaniline and a polyaniline derivative. Wiring and a predetermined flattened layer, for example, may be placedbetween the substrate and the anode. Since the anode containing polyaniline, a polyaniline derivative, or a mixture of polyaniline and a polyaniline derivative is formed by an application method, an organic photoelectric conversion element having high photoelectric conversion efficiency can be fabricated by a simple process.

The content of polyaniline and/or a polyaniline derivative in the anode is preferably 20% by weight or more, and more preferably 50% by weight or more with respect to the weight of the anode, and furthermore preferably, the anode consists essentially of polyaniline and/or a polyaniline derivative. A solution to be used in forming the anode by an application method contains a material for preparing the anode and a solvent. The material for preparing the anode is polyaniline and/or a polyaniline derivative, and these are preferably a polymer compound from the viewpoint of solubility. In the present specification, the polymer compound refers to a compound having a number average molecular weight on the polystyrene equivalent basis of 500 or more. Examples of the polyaniline and the polyaniline derivative include compounds including one or more of the following structural formulas as a repeating unit.

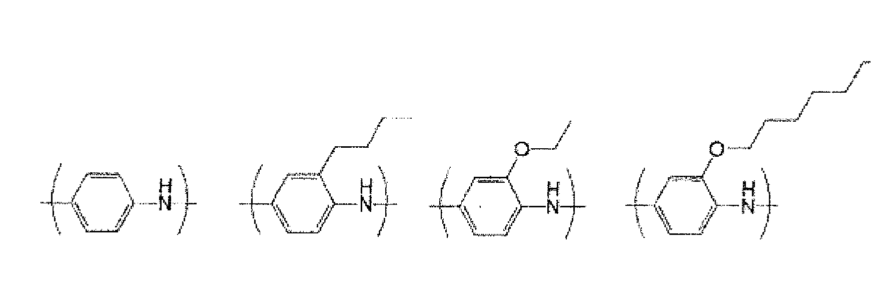

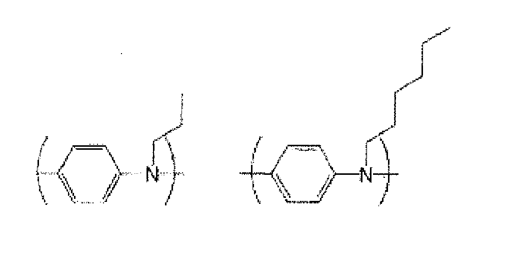

Since polyaniline, a polyaniline derivative, or a mixture of polyaniline and a polyaniline derivative is easily dissolved in solvents described later, it is suitably used as a solute of a coating solution to be used for the application method. Further, these compounds have high electric conductivity and are suitably used as electrode materials. Moreover, these compounds can be suitably used as anode materials because they have HOMO energy of about 5.0 eV and a difference between this energy and HOMO energy of a common active layer is as low as about 1 eV or less, and therefore a hole can be take out efficiently from the active layer.

Examples of the solvent of a solution to be used in forming an anode include hydrocarbon solvents such as toluene, xylene, mesitylene, tetralin, decalin, bicyclohexyl, n-butylbenzene, s-butylbenzene and t-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichlorobenzene and trichlorobenzene; ether solvents such as tetrahydrofuran and tetrahydropyran; water; and alcohols. Examples of the alcohols include methanol, ethanol, isopropanol, butanol, ethylene glycol, propylene glycol, butoxyethanol, and metoxybutanol. The solution used in the present invention may contain two or more solvents and may contain two or more solvents described above.

Examples of the application method include a spin coating method, a casting method, a microgravure coating method, a gravure coating method, a bar coating method, a roll coating method, a wire bar coating method, a dip coating method, a spray coatingmethod, a screen printing method, a flexo printing method, an offset printing method, and an ink jet printing method.

### (Active Layer)

As described above, the active layer is disposed between the anode and the cathode. The active layer may be composed of a single layer, or may be composed of a laminated body formed by stacking a plurality of layers.

The active layer is preferably composed of a single layer containing the electron acceptive compound and the electron donating compound. The electron acceptive compound is preferably a fullerene derivative from the viewpoint of including many heterojunction interfaces. A rate of the fullerene derivative in the active layer containing a fullerene derivative and an electron donating compound is preferably 10 to 1000 parts by weight, and more preferably 50 to 500 parts by weight with respect to 100 parts by weight of the electron donating compound.

The active layer may be composed of a first active layer containing the electron acceptive compound and a second active layer which is disposed adjacent to the first active layer and contains the electron donating compound. In this case, the first active layer is disposed on an anode side of the second active layer.

With respect to the electron acceptive compound suitably used for the organic photoelectric conversion element, its HOMO energy is higher than that of the electron donating compound, and its LUMO energy is higher than that of the electron donating compound.

Examples of the electron donating compounds include low molecular compounds and high molecular compounds. Examples of the low molecular compounds include phthalocyanine, metal phthalocyanines, porphyrin, metal porphyrins, oligothiophene, tetracene, pentacene, and rubrene. Examples of the high molecular compounds include polyvinylcarbazole and derivatives thereof, polysilane and derivatives thereof, polysiloxane derivatives having aromatic amine on the side chain or main chain, polyaniline and derivatives thereof, polythiophene and derivatives thereof, polypyrrole and derivatives thereof, polyphenylenevinylene and derivatives thereof, polythienylenevinylene and derivatives thereof, and polyfluorene and derivatives thereof.

Examples of the electron acceptive compound include low molecular compounds and high molecular compounds. Examples of the low molecular compounds include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complex of 8-hydroxyquinoline and derivatives thereof, polyquinoline and derivatives thereof, polyquinoxaline and derivatives thereof, polyfluorene and derivatives thereof, fullerenes such as C₆₀ and the like and derivatives thereof, and phenanthrene derivatives such as bathocuproin. Examples of the high molecular compounds include polyvinylcarbazole and derivatives thereof, polysilane and derivatives thereof, polysiloxane derivatives having aromatic amine on the side chain or main chain, polyaniline, and derivatives thereof, polythiophene and derivatives thereof, polypyrrole and derivatives thereof, polyphenylenevinylene and derivatives thereof, polythienylenevinylene and derivatives thereof, and polyfluorene and derivatives thereof.

Particularly, fullerene and derivatives thereof are preferable.

Examples of the fullerenes include fullerene and derivatives thereof such as C₆₀, C₇₀ and carbon nanotube. Examples of the derivatives of fullerene include the compounds shown below.

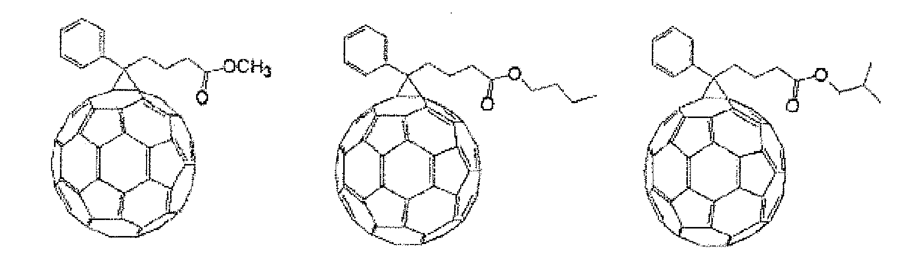

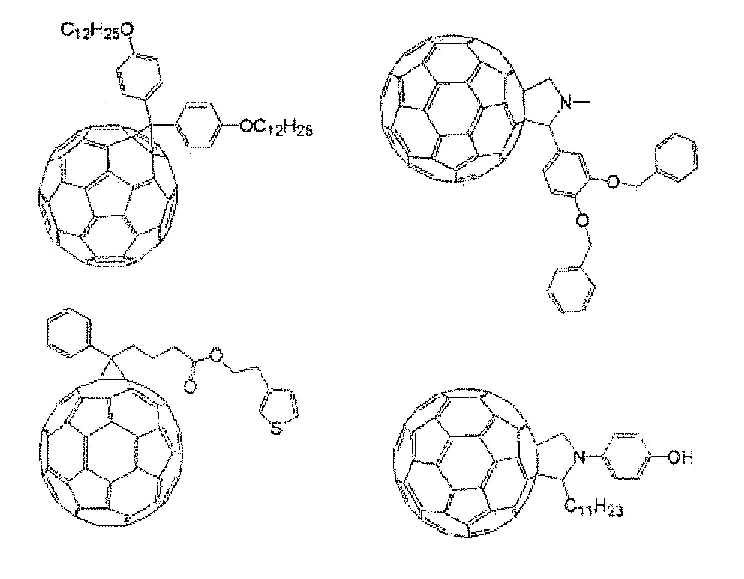

The active layer in the organic photoelectric conversion element of the present invention preferably contains a polymer compound, and may contain one polymer compound alone, or may contain the polymer compounds in combination of two or more species. In order to enhance a charge transporting property of the active layer, the electron donating compound and/or the electron acceptive compound may be mixed in the active layer to be used. Among these, a conjugated polymer compound and a fullerene derivative are preferably contained in the active layer. For example, an organic thin film containing the conjugated polymer compound and the fullerene derivative can be employed as an active layer. Examples of the conjugated polymer compound include polymer compounds having a fluorenediyl group, and polymer compounds having a thiophenediyl group.

The organic thin film to be used for the active layer can be formed, for example, by an application method using a solution containing material constituting the active layer described above and a solvent. For example, the organic thin film can be formed by the application method using a solution containing a conjugated polymer compound, a fullerene derivative and a solvent.

Examples of the solvent include hydrocarbon solvents such as toluene, xylene, mesitylene, tetralin,decalin,bicyclohexyl, n-butylbenzene, s-butylbenzeneandt-butylbenzene;halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichlorobenzene and trichlorobenzene; and ether solvents such as tetrahydrofuran and tetrahydropyran. The solution used in the present invention may contain two or more solvents and may contain two or more solvents described above.

Examples of the method of applying the solution containing material constituting the active layer include application methods such as a spin coating method, a casting method, a microgravure coating method, a gravure coating method, a bar coating method, a roll coating method, a wire bar coating method, a dip coating method, a spray coating method, a screen printing method, a flexo printing method, an offset printing method, an ink jet printing method, a dispenser printing method, a nozzle coating method and a capillary coating method, and among these methods, the spin coating method, the flexo printing method, the ink jet printing method, and the dispenser printing method are preferably used.

The film thickness of the organic thin film is usually 1 nm to 100 µm, preferably 2 nm to 1000 nm, more preferably 5 nm to 500 nm, and furthermore preferably 20 nm to 200 nm.

### (Cathode)

The cathode is disposed on a side opposite to an anode side on the substrate. In the organic photoelectric conversion element in which light is introduced through the cathode, the cathode is preferably composed of a transparent or translucent electrode. As described above, since the anode of the organic photoelectric conversion element of the present embodiment is transparent or translucent, an organic photoelectric conversion element having a configuration, in which light is introduced from both electrodes of the anode and the cathode, can be realized by using the transparent or translucent cathode and substrate. Conductive metal oxide films, translucent metal thin films or transparent conductive films containing organic substances are used for the transparent or translucent electrode. Specifically, thin films of indium oxide, zinc oxide, tin oxide, indium tin oxide (ITO), indium zinc oxide (IZO), gold, platinum, silver, copper, aluminum, polyaniline and derivatives thereof, as well as polythiophene and derivatives thereof or the like are used, and among these, thin films of ITO, IZO and tin oxide are suitably used.

In the organic photoelectric conversion element in which light is introduced from a side of a substrate, the cathode does not have to be transparent or translucent, and may be opaque. The material of such a cathode is preferably a material which has a small work function to facilitate the electron injection from the active layer and has a high electric conductivity, and examples of suchmaterials include alkali metals, alkaline-earth metals, transition metals and group-13 metals in a periodic table. Examples of such cathode materials include metals such as lithium, sodium, potassium, rubidium, cesium, beryllium, magnesium, calcium, strontium, barium, aluminum, scandium, vanadium, zinc, yttrium, indium, cerium, samarium, europium, terbium or ytterbium, or alloys of two or more thereof; alloys of one or more of the above-mentioned metals and one or more of gold, silver, platinum, copper, manganese, titanium, cobalt, nickel, tungsten and tin; or graphite or graphite interlayer compounds.

The cathode is prepared by forming the above-mentioned cathode materials into a film by a vacuum deposition method, a sputtering method, an ion plating method, a plating method or the like.

The film thickness of the cathode is usually 1 nm to 1 mm, preferably 10 nm to 100 µm, and more preferably 20 nm to 10 µm.

### (Functional Layer)

There may be cases where a predetermined layer is disposed between the anode and the active layer for the purpose of improving element characteristics such as conversion efficiency and life. One of such a layer includes a functional layer. It is preferable that the functional layer is placed between the active layer and the anode so as to be in contact with the active layer and the anode, and is formed by an application method using a solution with a pH of 5 to 9. In the present invention, measurement of the pH is carried out by use of a pH-test paper.

The functional layer is provided as a so-called hole transport layer, a hole injection layer, an electron blocking layer and the like. Examples of functions of the functional layer include a function of enhancing the efficiency of hole injection into the anode, a function of presenting the injection of an electron from the active layer, a function of enhancing a hole transporting power, and a function of suppressing the degradation of the active layer.

Examples of materials constituting the functional layer include polymer compounds having a thiophenediyl group, polymer compounds having an anilinediyl group, and polymer compounds having a pyrrolediyl group. A solution used in applying/forming a functional layer contains these materials constituting the functional layer and a solvent. For example, if a functional layer is applied/formed by use of a strong acid solution, a lower layer such as the anode may be damaged, but since the functional layer is formed by an application method using a solution with a pH of 5 to 9, it is possible to prevent the lower layer such as the anode from being damaged in forming the functional layer, and a highly reliable organic photoelectric conversion element can be fabricated. If using a strong acid solution, there is a possibility of damaging application equipment, but since the functional layer is formed by an application method using a solution with a pH of 5 to 9, the functional layer needs no use of special application equipment resistant to the acid solution, and an organic photoelectric conversion element can be easily prepared, and the cost required for preparation of the element can be controlled.

By disposing the functional layer in a state of being in contact with the anode, the adhesion of the functional layer to the anode can be enhanced and the efficiency of hole injection from the active layer into the anode can be enhanced. By disposing such a functional layer, a highly reliable organic photoelectric conversion element can be realized and by extension an organic photoelectric conversion element having small temporal degradation can be realized.

A solution to be used in applying and forming the functional layer contains the solvent and the above-mentioned materials constituting the functional layer. Examples of a solvent of the above-mentioned solution include water and alcohols, and examples of the alcohols include methanol, ethanol, isopropanol, butanol, ethylene glycol, propylene glycol, butoxyethanol, and metoxybutanol. The solution used in the present invention may contain two or more solvents and may contain two or more solvents described above. As an application method, the above-mentioned methods can be employed.

The film thickness of the functional layer is usually 1 to 1000 nm, preferably 2 to 500 nm, and more preferably 5 to 200 nm.

There may be cases where a hole injection layer having a function of improving hole injection efficiency, a hole transporting layer having a function of transporting a hole, and an electron blocking layer having a function of blocking electron transfer are disposed in addition to the above-mentioned functional layers between the anode and the active layer.

There may be cases where a predetermined layer is further disposed between the cathode and the active layer for the purpose of improving element characteristics, and for example, an electron transporting layer having a function of transporting an electron, an electron injection layer having a function of improving electron injection efficiency, a buffer layer having a function of accelerating flatness of the surface and electron injection, and a hole blocking layer having a function of blocking hole transfer are disposed. The buffer layer is disposed in a state of being in contact with the cathode. Examples of a material used for the buffer layer include halides and oxides of alkali metals and alkaline earth metals such as lithium fluoride. Examples of a material used for the buffer layer also include fine particles of inorganic semiconductor such as titanium oxide and the like.

### < Method for Fabricating Organic Photoelectric Conversion Element>

A method for fabricating an organic photoelectric conversion element of the present invention comprises the steps of forming an anode on a substrate by an application method, forming an active layer by an application method, and forming a cathode. Specifically, the organic photoelectric conversion element canbe fabricated by stacking each component constituting the organic photoelectric conversion element described above in order from a substrate side by use of the above-mentioned method.

The organic photoelectric conversion element of the present invention can be operated as an organic thin film solar cell since a photovoltaic power is generated between electrodes by being irradiated from a transparent or translucent electrode with light such as solar light.

The organic photoelectric conversion element of the present invention can also be used as an organic thin film solar cell module by integrating a plurality of organic thin film solar cells.

The organic photoelectric conversion element of the present invention can be operated as an organic optical sensor since a photocurrent flows by being irradiated from a transparent or translucent electrode with light in a state of applying a voltage between the electrodes. The organic photoelectric conversion element of the present invention can also be used as an organic image sensor by integrating a plurality of organic optical sensors.

### EXAMPLES

Hereinafter, examples will be described in order to explain the present invention in more detail, but the present invention is not limited to these examples.

In the following Examples, a number average molecular weight and a weight average molecular weight on the polystyrene equivalent basis of the polymer were determined by GPC (PL-GPC 2000) manufactured by GPC Laboratory. The polymer was dissolved in o-dichlorobenzene so as to be about 1% by weight in concentration. As the mobile-phase of GPC, o-dichlorobenzene was used and o-dichlorobenzene was passed at a flow rate of 1 ml/min at a measuring temperature of 140°C. As a column, three PLGEL 10 µm MIXED-Bs (manufactured by PL Laboratory) were connected in series.

### Synthesis Example 1

### (Synthesis of Polymer 1)

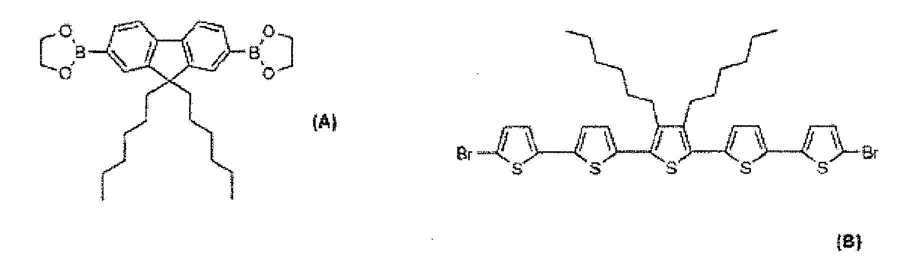

7.928 g (16.72 mmol) of the compound (A), 13.00 g (17.60 mmol) of the compound (B), 4.979 g of methyltrioctylammonium chloride (trade name: aliquat 336, manufactured by Aldrich
Chemical Company, Inc., CH₃N[(CH₂)₇CH₃]₃Cl, density 0.884 g/ml at 25°C, trademark of Henkel Corporation), and 405 ml of toluene were put in a 2 liter four-necked flask, the inside of which was replaced with an argon gas, and the inside of a system was bubbled for 30 minutes with an argon gas while being stirred to be aerated. To this, 0.02 g of dichlorobis(triphenylphosphine)palladium(II) was added, and to the resulting mixture, 42.2 ml of a 2 mol/L aqueous solution of sodium carbonate was added dropwise while heating at 105°C and stirring the mixture. After the completion of adding dropwise, the mixture was reacted for 5 hours, and 2.6 g of phenylboronic acid and 1.8 ml of toluene were added and the resulting mixture was stirred at 105°C for 16 hours. 700 ml of toluene and 200 ml of a 7.5% aqueous solution of sodium diethyldithiocarbamate trihydrate were added and the resulting mixture was stirred at 85°C for 3 hours. A water layer was removed and then the other portion was washed with 300 ml of ion-exchange water of 60°C two times, with 300 ml of a 3% acetic acid solution of 60°C one time, and with 300 ml of ion-exchange water of 60°C three times . An organic layer was passed through a column filled with cerite, alumina and silica, and the column was cleaned with 800 ml of hot toluene. A solution was concentrated to 700 ml and then added to 2 liter of methanol by injection to be reprecipitated. A polymer was obtained by filtration and washed with 500 ml of methanol, 500 ml of acetone and 500 ml of methanol. The polymer was dried under a vacuum at 50°C for one night to obtain 12.21 g of pentathienyl-fluorene copolymer (hereinafter, referred to as a "polymer 1") represented by the following formula (wherein n represents a natural number of 2 or more):

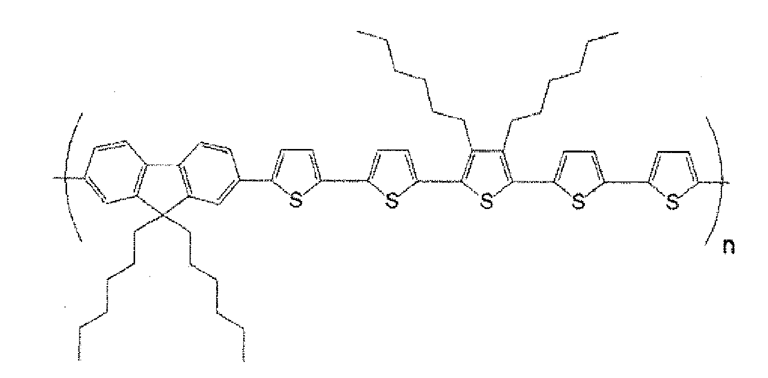

A number average molecular weight on the polystyrene equivalent basis of the polymer 1 was 5. 4 × 10⁴ and a weight average molecular weight on the polystyrene equivalent basis was 1.1 × 10⁵, respectively.

### (Production of Composition 1)

15 parts by weight of [6, 6] -phenyl-C₆₁-butyric acid methyl ester (PCBM) (E100 manufactured by Frontier Carbon Corp.) as a fullerene derivative, 5 parts by weight of the polymer 1 as an electron donating compound, and 1000 parts by weight of o-dichlorobenzene as a solvent were mixed. Thereafter, the resulting mixture was filtered with a Teflon (trademark) filter with pore size of 1.0 µm to prepare a composition 1.

### Example 1

### (Preparation of Organic Thin Film Solar Cell)

An anode composed of polyaniline was formed by applying a polyaniline solution (ORMECON D 1033W (water solvent) manufactured by Nissan Chemical Industries Co., Ltd.) onto a glass substrate and then heating the solution at 100°C for 10 minutes in the atmosphere. The film thickness of polyaniline was about 130 nm. The anode composed of the polyaniline was transparent.

Next, the composition 1 was applied onto the anode by spin coating to obtain an active layer (film thickness about 100 nm) . Thereafter, the active layer was dried under a reduced pressure for one hour, and by vapor deposition, lithium fluoride was deposited in a thickness of 4 nm as a cathode buffer layer, and as a cathode, calcium was deposited in a thickness of 5 nm and then aluminum was deposited in a thickness of 100 nm to prepare an organic photoelectric conversion element. A degree of vacuum at the time of vapor deposition was always 1 × 10⁻⁴ to 9 × 10⁻⁴ Pa.

### Example 2

### (Preparation of Organic Thin Film Solar Cell)

An anode composed of polyaniline was formed by applying a polyaniline solution (ORMECON D 1033W (water solvent) manufactured by Nissan Chemical Industries Co., Ltd.) onto a glass substrate and then heating the solution at 100°C for 10 minutes in the atmosphere. The film thickness of polyaniline was about 130 nm. The anode composed of the polyaniline was transparent. The film thickness of polyaniline was about 130 nm. The anode composed of the polyaniline was transparent. Thereafter, a HIL 691 solution (manufactured by Plextronics, Inc., trade name Plexcore HIL 691) was applied onto the anode by spin coating to obtain a hole transport layer (film thickness about 100 nm) which is a functional layer. The HIL 691 solution was measured with a pH test paper (manufactured by Advantec Toyo Kaisha, Ltd., trade name "UNIV (Universal)", catalog no. "07011030") and consequently the pH of the solution was 7.

Next, the composition 1 was applied onto the functional layer by spin coating to obtain an active layer (film thickness about 100 nm). Thereafter, the active layer was dried under a reduced pressure for one hour, and by vapor deposition, lithium fluoride was deposited in a thickness of 4 nm as a cathode buffer layer, and as a cathode, calcium was deposited in a thickness of 5 nm and then aluminum was deposited in a thickness of 100 nm to prepare an organic photoelectric conversion element. A degree of vacuum at the time of vapor deposition was always 1 × 10⁻⁴ to 9 × 10⁻⁴ Pa. One side of the functional layer is adjacent to the anode and the other side is adjacent to the active layer.

### (Preparation of Modified PEDOT/PSS Solution)

CLEVIOS PH500 manufactured by H.C. Starck GmbH., dimethylsulfoxide (DMSO), and a surfactant (manufactured by Air Products Japan Inc. , Surfynol 104PA (50% isopropanol solution)) were mixed in proportions by weight of 95: 5: 0. 8, and the resulting mixture was separated by a filter with pore size of 0.2 µm to prepare a modified PEDOT/PSS solution.

### Comparative Example 1

### (Preparation of Organic Thin Film Solar Cell)

An anode composed of the modified PEDOT was formed by applying the modified PEDOT/PSS solution prepared above onto a glass substrate and then heating the solution at 130°C for 10 minutes in the atmosphere.

The film thickness of the anode was about 130 nm. The anode composed of the modified PEDOT was transparent.

Next, the composition 1 was applied onto the anode by spin coating to obtain an active layer (film thickness about 100 nm)). Thereafter, the active layer was dried under a reduced pressure for one hour, and by vapor deposition, lithium fluoride was deposited in a thickness of 4 nm as a cathode buffer layer, and as a cathode, calcium was deposited in a thickness of 5 nm and then aluminum was deposited in a thickness of 100 nm to prepare an organic photoelectric conversion element. A degree of vacuum at the time of vapor deposition was always 1 × 10⁻⁴ to 9 × 10⁻⁴ Pa.

### Comparative Example 2

### (Preparation of Organic Thin Film Solar Cell)

An anode composed of the modified PEDOT was formed by applying the modified PEDOT/PSS solution prepared above onto a glass substrate and then heating the solution at 130°C for 10 minutes in the atmosphere.

The film thickness of the anode was about 130 nm. The anode composed of the modified PEDOT was transparent. Thereafter, a HIL 691 solution (manufactured by Plextronics, Inc., trade name Plexcore HIL 691) was applied onto the anode by spin coating to obtain a hole transport layer (film thickness about 100 nm) which is a functional layer.

The HIL 691 solution was measured with a pH test paper (manufactured by Advantec Toyo Kaisha, Ltd., trade name "UNIV (Universal)", catalog no. "07011030") and consequently the pH of the solution was 7.

Next, the composition 1 was applied by spin coating to prepare an active layer (film thickness about 100 nm) on the hole transport layer. Thereafter, the active layer was dried under a reduced pressure for one hour, and by vapor deposition, lithium fluoride was deposited in a thickness of 4 nm as a cathode buffer layer, and as a cathode, calcium was deposited in a thickness of 5 nm and then aluminum was deposited in a thickness of 100 nm to prepare an organic photoelectric conversion element. A degree of vacuum at the time of vapor deposition was always 1 × 10⁻⁴ to 9 × 10⁻⁴ Pa.

### -Evaluation-

The obtained organic thin film solar cell was covered with a square mask having a size of 2 mm × 2 mm and was irradiated with a certain amount of light using a solar simulator (trade name OTENTO-SUNI I manufactured by BUNKOUKEIKI Co. , Ltd. : AM 1. 5G Filter, irradiance 100 mW/cm²), and a current and a voltage generated were measured to determine photoelectric conversion efficiency. The results of measurements are shown in Table 1.

**Table 1**

| | Photoelectric conversion efficiency (%) |
|---|---|
| Example 1 | 2.4 |
| Example 2 | 2.2 |
| Comparative Example 1 | 1.4 |
| Comparative Example 2 | 2.0 |

As shown in Table 1, it was verified that the organic photoelectric conversion element provided with the anode formed by application of the polyaniline solution exhibited higher photoelectric conversion efficiency than the organic photoelectric conversion element provided with the anode formed by application of the modified PEDOT/PSS solution.

### Industrial Applicability

In the organic photoelectric conversion element of the present invention, it is possible to fabricate an organic photoelectric conversion element exhibiting high photoelectric conversion efficiency by a simple process since the anode containing polyaniline, a polyaniline derivative or a mixture of polyaniline and a polyaniline derivative is formed by an application method.

## Claims

1. An organic photoelectric conversion element comprising a cathode; an anode formed on a substrate by an application method; and an active layer disposed between the anode and the cathode; wherein the anode contains a polyaniline, a polyaniline derivative or a mixture of a polyaniline, and a polyaniline derivative.

2. The organic photoelectric conversion element according to claim 1, further comprising a functional layer which is placed between the active layer and the anode so as to be in contact with the active layer and the anode and is formed by an application method using a solution with a pH of 5 to 9.

3. The organic photoelectric conversion element according to claim 1 or 2, wherein the active layer is formed by an application method.

4. The organic photoelectric conversion element according to any one of claims 1 to 3, wherein the active layer contains a conjugated polymer compound and a fullerene derivative.

5. A method for fabricating an organic photoelectric conversion element comprising an anode, a cathode and an active layer disposed between the anode and the cathode, comprising the steps of:
forming an anode on a substrate by an application method using a coating solution containing polyaniline, a polyaniline derivative, or a mixture of polyaniline and a polyaniline, derivative;
forming an active layer by an application method; and
forming a cathode.
